# NEUE EUROPÄISCHE PATENTSCHRIFT

(11) **EP 3 066 429 B2**
(45) Veröffentlichungstag und Bekanntmachung des Hinweises auf die Entscheidung über den Einspruch: **06.09.2023**
(45) Hinweis auf die Patenterteilung: 04.04.2018
(21) Anmeldenummer: 14758302.5
(22) Anmeldetag: 02.09.2014
(51) Int. Cl.: G01G 21/28, G01G 23/48

(54) **PRÄZISIONSWAAGE MIT ABNEHMBAREM KLIMAMODUL**
PRECISION SCALE HAVING A REMOVABLE AIR-CONDITIONING MODULE
BALANCE DE PRÉCISION COMPORTANT UN MODULE DE CLIMATISATION AMOVIBLE

(30) Priorität: 08.11.2013 DE 102013018767; 07.02.2014 DE 102014101558
(43) Veröffentlichungstag der Anmeldung: 14.09.2016
(73) Patentinhaber: Sartorius Lab Instruments GmbH & Co. KG, 37079 Göttingen (DE)
(72) Erfinder: ESSER, Richard, 37120 Bovenden - Eddigehausen (DE); HOLST, Heyko, 37085 Göttingen (DE); MÜHLICH, Sigo, 37120 Bovenden (DE); HILBRUNNER, Falko, 98693 Ilmenau (DE); FEHLING, Thomas, 37218 Witzenhausen (DE); GATZEMEIER, Benno, 37085 Göttingen (DE); GUNKEL, Rainer, 37308 Schimberg (DE)
(74) Vertreter: Prinz & Partner mbB
(86) Internationale Anmeldenummer: PCT/EP2014/002365
(87) Internationale Veröffentlichungsnummer: WO 2015/067330

(56) Entgegenhaltungen:
- EP-A1- 1 785 703
- WO-A1-2013/163612
- DE-A1- 10 326 469
- DE-A1-102010 042 621
- DE-U1- 20 001 455
- DE-U1- 29 912 867
- DE-U1-202004 000 590
- US-B2- 9 354 109

## Beschreibung

Die Erfindung betrifft eine Präzisionswaage, also eine hochauflösende elektronische Waage mit einem abnehmbaren Klimamodul.

Bei hochauflösenden Waagen hat der Luftauftrieb, den das Wägegut erfährt, einen Einfluss auf die Genauigkeit des Messergebnisses. Für Messungen höchster Genauigkeit ist daher die Bestimmung der Luftdichte für die Ermittlung eines Luftauftriebskorrekturfaktors notwendig. Für Komparatorwaagen ist beispielsweise bekannt, dass der Luftauftriebskorrekturfaktor durch eine Vergleichsmessung zwischen zwei Referenzobjekten bestimmt wird, deren Masse und Dichte vorbekannt sind.

Es ist auch bekannt, dass Temperatur, Luftdruck und Feuchte auch die Waage selbst beeinflussen, insbesondere die Wägezelle. Aus diesem Grund werden zur Kompensation der Veränderungen der Waagenanzeige bei veränderten Umgebungsparametern Korrekturfaktoren im Gerät abgelegt, zum Beispiel in Form von Kurven oder Tabellen. Hierzu werden insbesondere im Bereich der Wägezelle Temperatur- und Luftfeuchtesensoren angeordnet, über die dann eine Korrektur der Waage selbst in Abhängigkeit von den sich ändernden Umgebungsbedingungen, auch Klimaänderungen genannt, automatisch erfolgt.

So beschreibt die DE 37 14 540 C2 ein Verfahren zum automatischen Kalibrieren einer hochauflösenden, elektronischen Waage, bei der für die Kalibrierung der Waage selbst Umgebungseinflüsse wie Temperaturänderung und Feuchtigkeitsänderung herangezogen werden, die extern erfasst werden. Der entsprechende Kalibrierfaktor wird von einem Computer ermittelt und korrigiert das Wägeresultat.

Aus der DE 299 12 867 U1 ist eine Analysenwaage mit Messwertaufnehmer für Umgebungsparameter bekannt, bei der eine Anzeige auf der Rückwand des Wägeraums vorgesehen ist. In dieser Anzeige werden die Temperatur im Wägeraum und die Luftfeuchte im Wägeraum angezeigt sowie allgemein der generell herrschende Luftdruck. Es wird dabei davon ausgegangen, dass bei einer feuchten Luft eine Feuchtebelegung der Oberfläche des Wägeguts erfolgt, die abhängig von den Änderungen der Luftfeuchte ist. Somit ist die Bedienperson über die Anzeige darüber informiert, dass beispielsweise bei sich ändernder Luftfeuchte das Wägegut länger im Wägeraum liegen sollte, um einen stabilen Endwert der Feuchtebelegung zu erreichen. Ergeben sich starke Luftdruckänderungen, so kann die Bedienperson eine sogenannte Auftriebskorrektur vornehmen, indem sie die angezeigten Daten über eine Eingabeeinheit dem Prozessor in der Waage liefert. Was die Temperatur anbelangt, so dient diese dazu, die Abweichung von der Referenztemperatur zu ermitteln und entsprechende Korrekturfaktoren zu berücksichtigen.

Schließlich gibt es auch klimatisierte Messräume, in denen Präzisionswaagen stehen, in die die Klimadaten des Messraumes eingegeben werden. Die Klimadaten aus der Klimaanlage oder deren Sensoren werden manuell oder automatisch in die Waage eingespeist.

Aufgabe der Erfindung ist es, eine Präzisionswaage zu schaffen, die kompakt ist und mit geringerem Aufwand eine verbesserte Messgenauigkeit gewährleistet.

Zur Lösung dieser Aufgabe ist erfindungsgemäß eine Präzisionswaage vorgesehen, mit einem Wägeraum, einem Windschutz, der den Wägeraum umgibt, einem Klimamodul, das einen Luftdrucksensor, einen Luftfeuchtesensor und einen Lufttemperatursensor enthält und abnehmbar in dem Wägeraum angeordnet ist, einem Prozessor, der in der Präzisionswaage angeordnet ist, einer Dateneingabeeinheit, die an der Präzisionswaage angeordnet ist, und einer Datenübertragungsstrecke, die ausgebildet ist, Daten zwischen dem Klimamodul und dem Prozessor auszutauschen.

Die Erfindung beruht auf dem Grundgedanken, sämtliche Bauteile und Funktionen, die für eine Klimakompensation von Wägewerten nötig sind, in die Präzisionswaage zu vereinen. Es sind daher keine externen Computer, Sensoren, etc. notwendig. Stattdessen kann dem Benutzer ein kompaktes Messlabor an die Hand gegeben werden, das mobil eingesetzt werden kann, da keine externen Sensoren, Computer, etc. mitgenommen werden müssen. Da das Klimamodul austauschbar (also zerstörungsfrei von der Waage lösbar) ist, kann es nach Bedarf zu einem externen Institut bzw. Dienstleister zum Kalibrieren geschickt werden. In der Zwischenzeit kann die Präzisionswaage weiter betrieben werden, indem ein Austausch-Klimamodul eingesetzt wird. Es kann also immer rollierend eines oder (bei mehreren Präzisionswaagen) mehrere der Klimamodule beim Kalibrieren sein, während mit den übrigen Klimamodulen gemessen wird.

Hinsichtlich des Klimamoduls ergibt sich als weiterer Vorteil, dass ältere Waagen nachgerüstet werden können. Es muss hierzu neben der Datenübertragungsstrecke lediglich die Software des Prozessors ergänzt werden.

Hinsichtlich der Genauigkeit hat die erfindungsgemäße Präzisionswaage den Vorteil, dass die Klimadaten im Windschutz (und nicht nur in dem Raum, in dem sich die Waage befindet) gemessen werden. Es wird also exakt die für die Auftriebskorrektur relevante Luftdichte ermittelt. Außerdem können, da die Klimadaten automatisch an den Prozessor übersandt werden, Übertragungsfehler praktisch ausgeschlossen werden, wie sie beim Übertragen von Werten aus dem sogenannten Kalibrierschein in die Kalibriersoftware nach der DE 299 12 867 U1 oder dem Einlesen von Klimadaten externer Sensoren möglich sind.

Gemäß einer Ausführungsform ist vorgesehen, dass das Klimamodul mittels einer elektrischen Steckverbindung mit dem Prozessor verbunden ist. Die Steckverbindung kann in eine mechanische Aufnahme integriert sein, die zur Anbringung des Klimamoduls an der Präzisionswaage dient. Auf diese Weise wird die Datenübertragungsstrecke zum Prozessor automatisch dann erstellt, wenn das Klimamodul innerhalb des Windschutzes an seinem Platz angeordnet wird.

Gemäß einer alternativen Ausführungsform ist vorgesehen, dass das Klimamodul mittels einer Funkübertragung mit dem Prozessor gekoppelt ist. In diesem Fall kann das Klimamodul an einer beliebigen Stellen innerhalb des Windschutzes angeordnet werden, beispielsweis an einer Begrenzungswand, an der es am wenigsten stört, ohne dass darauf Rücksicht genommen werden muss, ob an dieser Stelle sinnvoll eine Steckverbindung angeordnet werden kann. Außerdem ist der Verzicht auf eine Steckverbindung dahingehend vorteilhaft, dass der Innenraum der Wägekabine glatter und damit besser reinigbar ausgeführt werden kann.

Erfindungsgemäß enthält das Klimamodul einen Luftdrucksensor, einen Luftfeuchtesensor und einen Lufttemperatursensor. Mit diesen Sensoren können die für eine präzise Messung wesentlichen Klimadaten aufgenommen werden.

Es kann zusätzlich vorgesehen sein, dass innerhalb des Klimamoduls ein Sensor, welcher mit dem Prozessor gekoppelt ist, vorhanden ist und ausgebildet ist, den Ionisationsgrad im Wägeraum zu bestimmen. Dadurch kann ein zusätzlicher Parameter bestimmt und bei der Korrektur des Wägewerts berücksichtigt werden. Abhängig von dem bestimmten Ionisationsgrad wird vom Prozessor ein Ausgangssignal erzeugt, z.B. um den Ionisationsgrad aktiv zu verändern, indem eine Ionisationseinrichtung verwendet wird, die ab Erreichen bestimmter Ionisationsgrade aktiviert wird. Ferner kann auch eine Anzeige dem Benutzer darauf hinweisen, dass der Ionisationsgrad innerhalb des Wägeraumes zu hoch ist und entladen werden sollte.

Es kann auch vorgesehen sein, dass ein Lichtsensor im Klimamodul vorhanden ist, welcher mit dem Prozessor gekoppelt ist. Dadurch kann ein wiederum weiterer Parameter bestimmt und bei der Korrektur des Wägewerts berücksichtigt werden. Der Prozessor kann ab einem vorgegebenen Lichteinfall ein Ausgangssignal abgeben. Der Einfluss des Lichteinfalls auf den Wägeprozess ist damit bestimmbar, um gegebenenfalls Maßnahmen im Prozess selbst zu ergreifen. Das Ausgangssignal kann auch eine Anzeige sein.

Gemäß einer Ausführungsform ist vorgesehen, dass der Prozessor so ausgebildet ist, dass er auf Basis der Dichte des Wägeguts aus dem Luftdruck, der Luftfeuchte und der Lufttemperatur im Wägeraum den Luftauftrieb zumindest des Prüflings sowie den Auftriebskorrekturfaktor ermittelt. Auf diese Weise können vom Klimamodul metrologisch rückführbare Klimawerte zeitsynchron zur Übernahme des Massewertes erhalten werden, mit denen der Prozessor in der Lage ist, den Wägewert zu korrigieren.

Gemäß einer Ausführungsform ist innerhalb des Klimamoduls ein elektronischer Speicher vorgesehen, insbesondere ein EEPROM, der von außen auslesbar ist und auf dem Kalibrierwerte und Korrekturwerte für das Klimamodul abgelegt werden können. Zum Justieren können die Kalibrierwerte auf einem elektronischen Speicher auf dem Klimamodul abgelegt werden, insbesondere auf einem EEPROM. Dies geschieht bei einem externen Dienstleister. Wenn das Klimamodul dann wieder an die Präzisionswaage angekoppelt wird, stehen diese Daten dem Prozessor der Waage unmittelbar zur Verfügung. Zusätzlich können auf dem Speicher unter anderem zumindest einige der folgenden Informationen zur Sensorkalibrierung abgelegt werden: Nummer des Kalibrierscheins, aktuelle Kalibrierwerte, Kalibrierdatum, Name des Kalibrierlabors und des Bearbeiters sowie Kalibrierhistorie. Auf dem Speicher des Klimamoduls können auch sogenannte Unsicherheitswerte für jede Klimagröße abgelegt sein, sodass zum Beispiel zur Berechnung der Luftdichte ebenso die Berechnung der Unsicherheit der Luftdichte durch die Präzisionswaage erfolgt.

Gemäß einer Ausgestaltung ist vorgesehen, dass das Klimamodul auch außerhalb einer Waage als selbständige Einheit einsetzbar ist und über einen I²C-Bus an einen USB-Port eines PC anschließbar ist. Dies erleichtert das externe Kalibrieren. Außerdem kann das Klimamodul in anderen Anwendungen dafür eingesetzt werden, Klimagrößen aufzunehmen, ohne dass es an eine Waage angeschlossen ist. Die Leiterplatte des Klimamoduls kann hierfür mit geringem Aufwand einen Steckfortsatz aufweisen, um an einen USB-Adapter angeschlossen werden zu können.

Weitere Merkmale und Vorteile der Erfindung ergeben sich aus der nachfolgenden Beschreibung und aus den nachfolgenden Zeichnungen, auf die Bezug genommen wird. In den Zeichnungen zeigen:
- Figur 1 eine Explosionsansicht einer erfindungsgemäßen Präzisionswaage,
- Figur 2 eine Perspektivansicht eines Klimamoduls, das bei der erfindungsgemäßen Präzisionswaage eingesetzt werden kann,
- Figur 3 eine Seitenansicht des Klimamoduls nach Figur 2 ohne Außengehäuse, und
- Figur 4 eine Draufsicht auf das Klimamodul von Figur 2, ebenfalls ohne Außengehäuse.

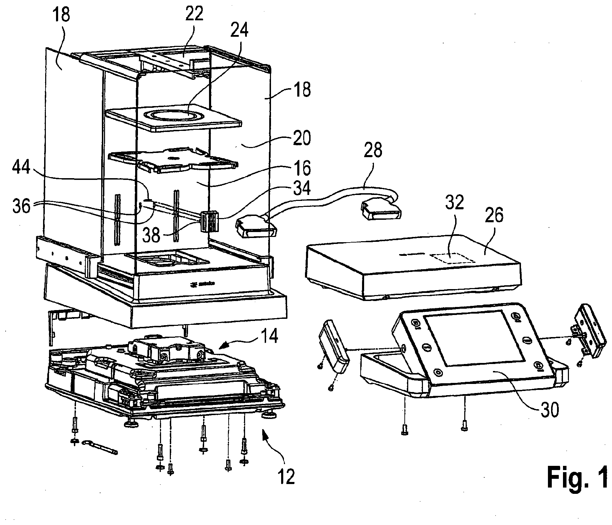

In Figur 1 ist eine hochauflösende elektronische Waage (Präzisionswaage) dargestellt, die in diesem Ausführungsbeispiel Massevergleiche in den Genauigkeitsklassen E1 - F2 nach OIML R 111-1 ermöglicht.

Die Erfindung betrifft aber generell jede hochauflösende elektronische Waage hoher Genauigkeit, also mit einer Messauflösung im Bereich von Mikrogramm bis hinunter zu Nanogramm.

Die Präzisionswaage umfasst eine Wägezelle 14 mit einer Basis 12, in welche ein nicht näher dargestelltes Wägesystem 10 untergebracht ist. Die Wägezelle 14 umfasst darüber hinaus einen Wägeraum 16, der durch einen Windschutz mit verstellbaren Seitenwänden 18, einer Frontwand 20 sowie einer Rückwand 22 ausgebildet ist. Über den Windschutz ist der Wägeraum 16 zur Umgebung abgetrennt. Eine Waagschale 24 dient zum Auflegen des Wägeguts.

Ein hier als separates Teil ausgeführtes elektronisches Auswertesystem 26 ist über ein Kabel 28 mit der Wägezelle 14 elektronisch gekoppelt. Eine Anzeigeeinheit 30, die mit dem Auswertesystem 26 gekoppelt ist, dient sowohl als Anzeige als auch als Dateneingabeeinheit.

Im elektronischen Auswertesystem 26 ist unter anderem ein Prozessor 32 untergebracht, der Daten von der Wägezelle 14 erhält.

Im Wägeraum 16 ist ein als baulich separate Einheit ausgeführtes Klimamodul 34 vorgesehen, welches über eine lösbare Steckverbindung mechanisch mit der Rückwand 22 koppelbar ist (also zerstörungsfrei lösbar angebracht ist), und zwar vorzugsweise ohne Zuhilfenahme eines Werkzeugs.

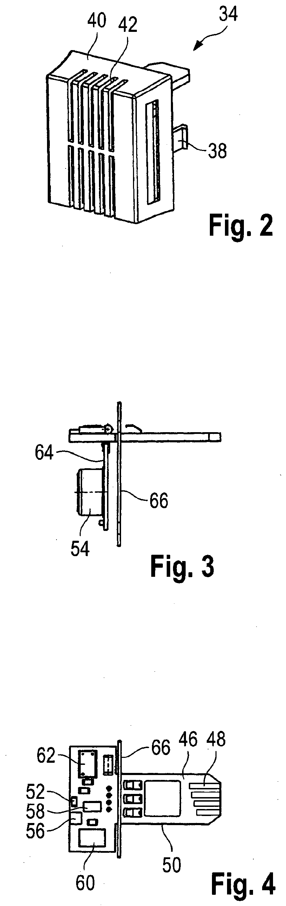

Hierzu weist die Rückwand 22 zwei von einander beabstandete Schlitze 36 auf, in die flexible Rasthaken 38 (siehe auch Figur 2) am Außengehäuse 40 des Klimamoduls einrasten.

In den Figuren 2 bis 4 ist das Klimamodul 34 näher dargestellt.

Das Außengehäuse 40 hat zahlreiche Öffnungen 42, über die das Innere des Außengehäuses 40 in den Wägeraum 16 übergeht und Teil des Wägeraums 16 wird, sodass das Klima im Inneren des Wägeraums 16 dem im Inneren des Außengehäuses 40 entspricht.

Das Klimamodul 34 ist elektronisch über eine elektrische Steckverbindung mit einer entsprechenden Steckeraufnahme 44 in der Rückwand 22 gekoppelt. Die Steckeraufnahme 44 steht elektrisch mit dem Prozessor 32 in Verbindung. In die Steckeraufnahme 44 wird ein Stecker 46 mit Kontakten 48 am Klimamodul 34 eingesteckt. Somit bildet der Stecker 46 einen modulseitigen Teil der elektrischen Steckverbindung.

Alternativ zu einer elektrischen Steckverbindung kann eine Funkübertragung, beispielsweise WLAN oder Bluetooth, verwendet werden.

Die elektrische Steckverbindung (oder die alternativ verwendete Funkübertragung) bildet eine Datenübertragungsstrecke, mit der Daten vom Klimamodul 34 zum Prozessor 32 und ggfls. zurück übertragen werden können.

Der Stecker 46 ist vorzugsweise ein Abschnitt einer Leiterplatte 50, auf der mehrere Sensoren zum Erfassen des Klimas im Wägeraum 16 angeordnet sind. So sind ein Lufttemperatursensor 52, eine Luftfeuchtesensor 54, ein unmittelbar in der Nähe einer Öffnung 42 angeordneter Lichtsensor 56 sowie ein Sensor 58 zum Erfassen des Ionisationsgrads im Wägeraum 16 auf der Leiterplatte 50 vorgesehen, ebenso wie ein elektronischer Speicher 60. Ein Luftdrucksensor 62 ist über eine Halterung 64 mit der Leiterplatte 50 mechanisch und elektrisch gekoppelt.

Mehrere der Sensoren können auch zu kombinierten Sensoren zusammengefasst sein.

Eine Wand 66 schließt das schalenartige Außengehäuse 40, sodass der schmale, zungenartige, in Figur 4 rechts von der Wand 66 liegende Abschnitt der Leiterplatte 50 in die Rückwand 22 und die Steckeraufnahme 44 einsteckbar ist.

Über entsprechende Kontakte 48 ist jeder Sensor mit dem Prozessor 32 gekoppelt. Ebenso ist der Speicher 60 mit dem Prozessor 32 gekoppelt.

Bei einem Wägevorgang kann die Dichte des Wägeguts in die Präzisionswaage eingegeben werden, beispielsweise über die Anzeigeeinheit 30, die gleichzeitig zum Beispiel auch über Touch-Screen als Dateneingabeeinheit dient. Alternativ kann die Dichte des Wägeguts bereits hinterlegt sein.

Dann wird ein Wägegut auf die Waagschale 24 aufgelegt.

Der Luftdruck, die Luftfeuchte und die Lufttemperatur werden über die Sensoren 62, 54 bzw. 52 ermittelt, und die entsprechenden Daten werden an den Prozessor 32 weitergeleitet.

Im Prozessor 32 wird die Luftdichte bestimmt. Mit den eingegebenen Dichten wird im Prozessor der Luftauftriebskorrekturfaktor und/oder der Luftauftrieb des Wägeguts abhängig vom Luftdruck, der Luftfeuchte, der Lufttemperatur sowie der Dichte des Wägeguts ermittelt und der konventionelle Wägewert des Wägeguts, d.h. die um ihren Luftauftrieb korrigierte Masse des Wägeguts, bestimmt und in der Anzeigeeinheit 30 angezeigt.

Darüber hinaus kann der Wägewert des Wägeguts anhand von weiteren Parametern korrigiert werden, beispielsweise um einen bekannten Einfluss von unterschiedlichen Luftfeuchten oder Temperaturen auf den Wägewert. Auf diese Weise kann die Genauigkeit des Wägewerts weiter gesteigert werden.

Darüber hinaus sind im Speicher 60 Kalibrierwerte und Korrekturwerte für das Klimamodul 34 abgelegt, die beim Kalibrieren des Klimamoduls 34 hinterlegt wurden.

Dieses Kalibrieren erfolgt außerhalb der Präzisionswaage. Hierzu wird das Klimamodul 34 einfach vom Wägeraum 16 aus ausgesteckt, ohne dass eine Drahtverbindung gelöst werden müsste. Das Klimamodul 34 wird dann zu einem entsprechenden Kalibrierinstitut geschickt, das die Nummer des Kalibrierscheins, das heißt die neuen Kalibrierwerte, das Kalibrierdatum, den Namen des Kalibrierlabors und des Bearbeiters und die Kalibrierhistorie auf dem Speicher 60 ablegt. Diese Werte werden vom Applikationsprogramm später, wenn das Klimamodul 34 wieder in der Präzisionswaage angeordnet ist, ausgelesen und fließen direkt in die Berechnung ein.

Auch die Werte des Lichtsensors 56 und des Sensors 58 zur Bestimmung des Ionisationsgrads im Wägeraum 16 werden bestimmt.

Beispielsweise wird bei erhöhtem Lichteinfall ein entsprechendes Signal auf der Anzeige angegeben werden, dass beispielsweise die Messung aufgrund erhöhter Sonneneinstrahlung und damit veränderter Temperatur im Wägeraum ungenau ist. Somit wird vom Prozessor ein Ausgangssignal abhängig vom Lichteinfall abgegeben.

Sobald der Ionisationsgrad zu hoch ist, wird eine Ionisationseinrichtung aktiviert, die die Luft im Wägeraum ionisiert und für eine Entladung des Wägeguts sorgt, oder es wird vor einer zu hohen Ladung des Wägeguts gewarnt.

Der Speicher 60 ist vorzugsweise ein EEPROM.

Darüber hinaus ist die Verbindung zwischen dem Klimamodul 34 und dem Rest der Präzisionswaage über einen I²C-BUS realisiert.

Das Klimamodul 34 kann über einen USB-Adapter, in den es eingesteckt wird, an einen Computer angeschlossen werden, um die Sensoren 52 bis 58 und 62 zu kalibrieren, ohne dass das Klimamodul 34 an die Präzisionswaage 10 angeschlossen sein muss.

Wie zu erkennen ist, ist das Klimamodul so ausgebildet ist, dass es auch außerhalb einer Waage als selbständige Einheit einsetzbar ist und über einen I²C-Bus an einen USB-Port eines PC anschließbar ist.

## Patentansprüche

1. Präzisionswaage mit einem Wägeraum (16), einem Windschutz (18, 20), der den Wägeraum (16) umgibt, einem Klimamodul (34), das einen Luftdrucksensor (62), einen Luftfeuchtesensor (54) und einen Lufttemperatursensor (52) enthält und abnehmbar im Wägeraum (16) angeordnet ist, einem Prozessor (32), der in der Präzisionswaage angeordnet ist, einer Dateneingabeeinheit, die an der Präzisionswaage angeordnet ist, und einer Datenübertragungsstrecke, die ausgebildet ist, Daten zwischen dem Klimamodul (34) und dem Prozessor (32) auszutauschen.

2. Präzisionswaage nach Anspruch 1, **dadurch gekennzeichnet, dass** das Klimamodul (34) mittels einer elektrischen Steckverbindung mit dem Prozessor (32) verbunden ist.

3. Präzisionswaage nach Anspruch 1, **dadurch gekennzeichnet, dass** das Klimamodul (34) mittels einer Funkübertragung mit dem Prozessor (32) gekoppelt ist.

4. Präzisionswaage nach einem der vorhergehenden Ansprüche, **dadurch gekennzeichnet, dass** im Klimamodul (34) ein Sensor (58), welcher mit dem Prozessor (32) gekoppelt ist, vorhanden ist und ausgebildet ist, den Ionisationsgrad im Wägeraum (16) zu bestimmen.

5. Präzisionswaage nach einem der vorhergehenden Ansprüche, **dadurch gekennzeichnet, dass** im Klimamodul (34) ein Lichtsensor (56) vorhanden ist, welcher mit dem Prozessor (32) gekoppelt ist.

6. Präzisionswaage nach einem der vorhergehenden Ansprüche, **dadurch gekennzeichnet, dass** der Prozessor (32) so ausgebildet ist, dass er auf Basis der Dichte des Wägeguts aus dem Luftdruck, der Luftfeuchte und der Lufttemperatur im Wägeraum (16) den Luftauftrieb zumindest des Prüflings oder den Auftriebskorrekturfaktor ermittelt.

## Claims

1. Precision weighing machine with a weighing chamber (16), a draught protector (18, 20) surrounding the weighing chamber (16), a climate module (34) which includes an air pressure sensor (62), a humidity sensor (54) and an air temperature sensor (52) and which is removably arranged in the weighing chamber (16), a processor (32) arranged in the precision weighing machine, a data input unit arranged at the precision weighing machine, and a data transmission path configured to exchange data between the climate module (34) and the processor (32).

2. Precision weighing machine according to claim 1, **characterised in that** the climate module (34) is connected with the processor (32) by means of an electrical plug connection.

3. Precision weighing machine according to claim 1, **characterised in that** the climate module (34) is coupled with the processor (32) by means of radio transmission.

4. Precision weighing machine according to any one of the preceding claims, **characterised in that** a sensor (58) coupled with the processor (32) is present in the climate module (34) and configured to determine the degree of the ionisation in the weighing chamber (16).

5. Precision weighing machine according to any one of the preceding claims, **characterised in that** a light sensor (56) coupled with the processor (32) is present in the climate module (34).

6. Precision weighing machine according to any one of the preceding claims, **characterised in that** the processor (32) is so constructed that on the basis of the density of the material to be weighed it determines from the air pressure, humidity and air temperature in the weighing chamber (16) the air buoyancy at least of the test item or the buoyancy correction factor.

## Revendications

1. Balance de précision avec un espace de pesée (16), un pare-vent (18, 20) entourant l'espace de pesée (16), un module de climatisation (34) comprenant un capteur de pression de l'air (62), un capteur d'humidité de l'air (54) et un capteur de température de l'air (52), et disposé de manière amovible dans l'espace de pesée (16), un processeur (32) disposé dans la balance de précision, une unité d'entrée de données disposée sur la balance de précision, et une voie de transmission de données prévue pour l'échange de données entre le module de climatisation (34) et le processeur (32).

2. Balance de précision selon la revendication 1, **caractérisée en ce que** le module de climatisation (34) est relié au processeur (32) au moyen d'une connexion par fiche électrique.

3. Balance de précision selon la revendication 1, **caractérisée en ce que** le module de climatisation (34) est couplé au processeur (32) au moyen d'une transmission radio.

4. Balance de précision selon l'une des revendications précédentes, **caractérisée en ce qu'**un capteur (58) est présenté dans le module de climatisation (34), lequel est couplé au processeur (32) et est destiné à déterminer le degré d'ionisation dans l'espace de pesée (16).

5. Balance de précision selon l'une des revendications précédentes, **caractérisée en ce qu'**un capteur de lumière (56) est présenté dans le module de climatisation (34), lequel est couplé au processeur (32).

6. Balance de précision selon l'une des revendications précédentes, **caractérisée en ce que** le processeur (32) est réalisé de manière à déterminer la poussée aérostatique au moins de l'échantillon ou le facteur de correction de poussée sur la base de la densité de la matière à peser, à partir de la pression de l'air, de l'humidité de l'air et de la température de l'air dans l'espace de pesée (16).
